(19) [Europäisches Patentamt / European Patent Office / Office européen des brevets]

(11) **EP 1 847 850 B1**

(12) **EUROPEAN PATENT SPECIFICATION**

(45) Date of publication and mention
of the grant of the patent:
**24.04.2013 Bulletin 2013/17**

(51) Int Cl.:
*G01V 1/18* (2006.01)

(21) Application number: **07012105.8**

(22) Date of filing: **08.03.2000**

(54) **Hydrophone assembly**

Hydrophonanordnung

Ensemble hydrophone

(84) Designated Contracting States:
**DE FR GB NL**

(30) Priority: **17.03.1999 US 125076 P**

(43) Date of publication of application:
**24.10.2007 Bulletin 2007/43**

(62) Document number(s) of the earlier application(s) in
accordance with Art. 76 EPC:
**00916159.7 / 1 183 555**

(73) Proprietor: **ION Geophysical Corporation
Houston, TX 77042-2839 (US)**

(72) Inventor: **Bednar, Eugene, D.
Houston
Texas 77036 (US)**

(74) Representative: **Jeffrey, Philip Michael
Dehns
St Bride's House
10 Salisbury Square
London
EC4Y 8JD (GB)**

(56) References cited:
**US-A- 4 091 356      US-A- 4 253 164
US-A- 5 408 440**

EP 1 847 850 B1

**Description**

The present invention relates to hydrophones employed in seismic exploration. More particularly, the invention relates to an improved hydrophone circuit that provides the frequency response characteristics of an accelerometer.

Due to the increasing difficulty and cost of finding petroleum resources in the world today, exploration techniques are becoming more and more technologically sophisticated. For example, many have found crystal hydrophones to be useful in petroleum exploration. Basically, hydrophones are used to measure seismic waves created by a source such as an air gun or a dynamite charge, to obtain detailed information about various sub-surface strata of earth.

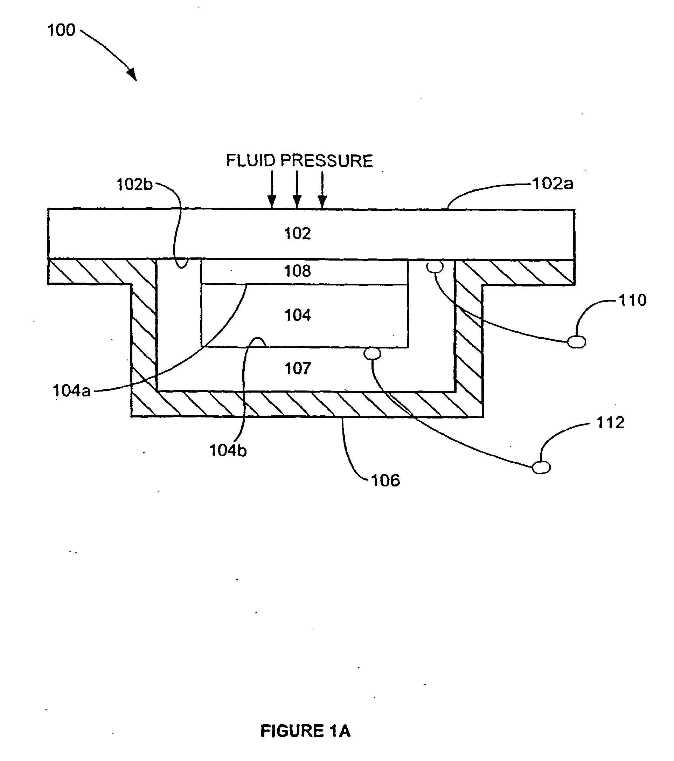

As shown in FIG. 1A, a typical crystal hydrophone 100 includes a diaphragm 102, a crystal 104, and a housing 106 that is typically filled with a gas 107. The diaphragm 102, which has front and rear sides 102a, 102b, is made from a material such as Kovar or a Beryllium Copper compound, and is electrically connected to the crystal by a conductive epoxy 108. The crystal 104 is typically made from a material such as Lead Zirconium Titanate, and is silver-plated on its top 104a and bottom 104b to achieve better conductivity. The crystal 104 is initially polarized by applying a high-voltage electrical charge to the crystal 104. When the polarized crystal 104 experiences pressure resulting from a physical input such as sound, fluid pressure, or another type of pressure, it produces a voltage representative of the pressure experienced. The crystal 104 is electrically connected to electrical output leads 110, 112. To protect the crystal 104 from contaminants, and to maintain the crystal 104 in atmospheric pressure, the crystal 104 and the rear side 102b of the diaphragm 102 are sealed within the gas-filled housing 106. The housing 106 protects the crystal 104 and diaphragm 102, and facilitates mounting of the hydrophone 100.

The diaphragm 102 functions to vibrate in response to physical pressures it experiences. The physical deflection of the diaphragm 102 is transferred by the epoxy 108 to the crystal 104, deforming the electron structure of the crystal 104 and causing an electrical potential to be provided across the leads 110, 112.

Another apparatus that is also useful in petroleum exploration is the accelerometer. Accelerometers are commonly used to measure the motion of the earth's surface in response to seismic waves created by a seismic source, to obtain detailed information about various sub-surface strata in the earth.

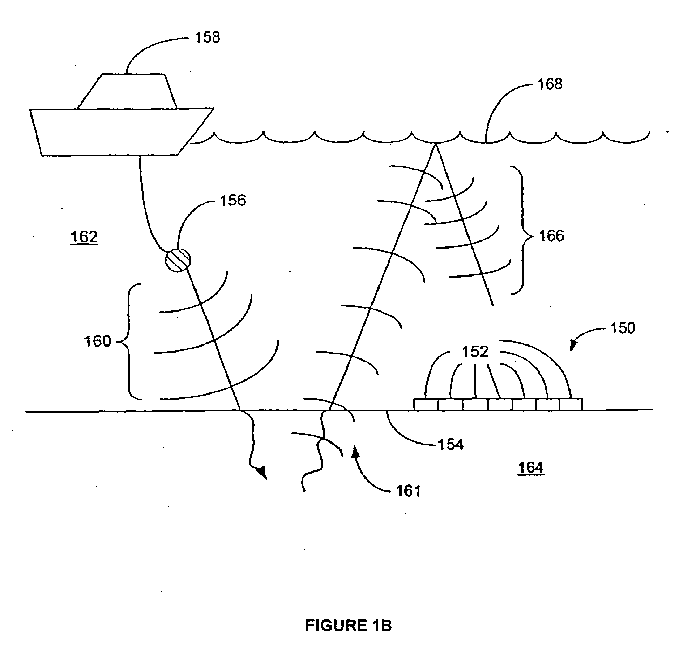

As mentioned above, hydrophones and accelerometers are often used in petroleum exploration in conjunction with seismic equipment. In one example of such an application (FIG. 1B), a cable 150 including one or more hydrophones and one or more accelerometers is placed on the sea floor 154. Such a cable may be made up of cylindrical units 152, where each unit 152 includes a geophone and an accelerometer.

Seismic waves are produced by a seismic source 156 that is towed behind a ship 158; the seismic source 156 may comprise an air gun, a dynamite charge, or the like. The seismic source 156 produces a large explosion, creating seismic waves 160. The seismic waves 160 travel through water 162 and various layers of earth 164, and are reflected back to the cable 150 as upgoing incident waves 161. Each unit 152 detects and measures the incident waves 161 and creates a real-time record of the results. This record is typically stored in a recorder (not shown) that is linked to or contained within the cable 150. Records of this nature help geologists determine the makeup of the earth 164.

One problem with this arrangement, however, is surface ghost signals 166. Surface ghost signals 166 are produced by incident waves 161 that are reflected from the water's surface 168. At the wavelengths typically used for seismic signals, the surface 168 provides an effective mirror to reflect incident waves 161 and create downgoing surface ghost signals 166. Surface ghost signals 166 contain no additional information regarding the composition of the earth 164 or the possible petroleum deposits therein, and they interfere with the proper receipt and interpretation of the incident waves 161. Accordingly, it is desirable to eliminate the errors introduced by the surface ghost signals 166.

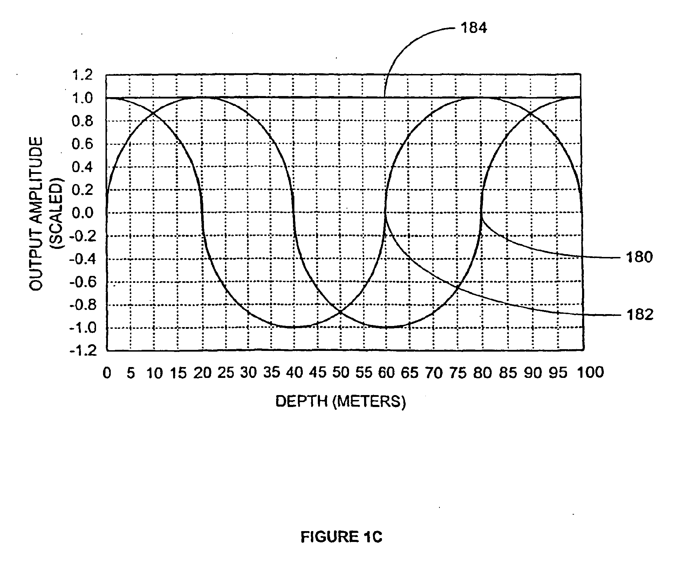

A hydrophone-accelerometer combination, in theory, is naturally suited to eliminate surface ghost signals. Generally, hydrophones detect pressure omnidirectionally, and accelerometers detect force or acceleration, which is directional. Due to the relative strengths of the incident waves 161 and the surface ghost signals 166 at different depths, a hydrophone's output and an accelerometer's output will both vary with depth. For a seismic wave 161 of a given magnitude and frequency, a hydrophone's output will vary with depth sinusoidally (curve 180, FIG. 1C). Likewise, for the given seismic wave 161, an accelerometer's output will vary sinusoidally with depth (curve 182, FIG. 1C). The hydrophone and accelerometer outputs may be scaled by external circuitry or by a mathematical algorithm in a computer, so that their peak values have the same amplitude; for example, in FIG. 1C, the hydrophone and accelerometer outputs are scaled to a maximum peak amplitude of 1 and a minimum peak amplitude of -1. After such scaling, the sum of the hydrophone and accelerometer outputs will always be 1, irrespective of the depth at which the hydrophone and accelerometer are both located (curve 184, FIG. 1C). Therefore, in theory, a hydrophone output and an accelerometer output may be combined to effectively eliminate the influence of surface ghost signals 166.

One problem in applying this theory is that the frequency responses of hydrophones and accelerometers differ. Therefore, the hydrophone and accelerometer outputs will only complement each other as shown in FIG. 1C when the seismic wave 160 has a certain frequency. As a result, if the frequency of the seismic wave 160 were to change, the combined hydrophone-accelerometer output 184 would no longer be constant.

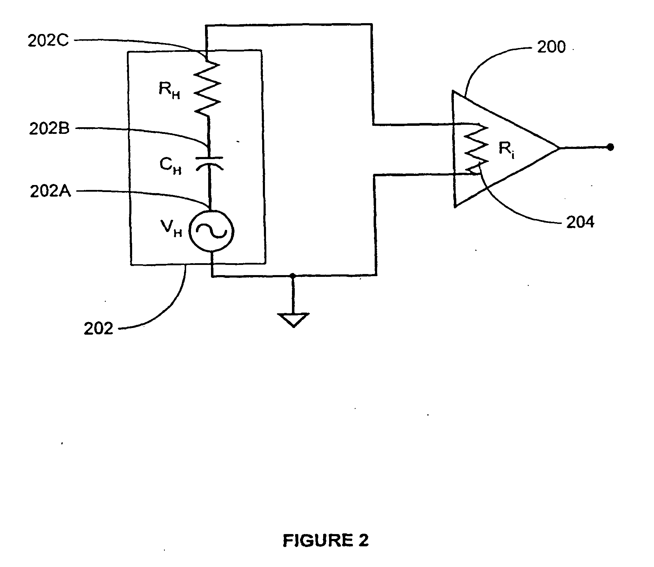

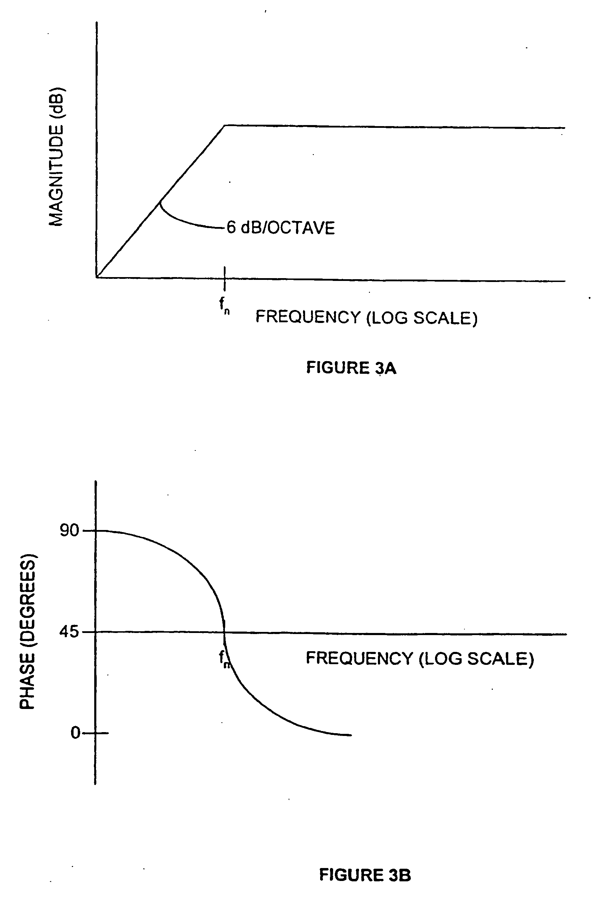

The difference between frequency responses of hydrophones and accelerometers will now be explained with reference to FIGS. 2-4B. When an electronic amplifier 200 (FIG. 2) is utilized to amplify the output of a typical hydrophone 202, the frequency response of the hydrophone 202 (FIGS. 3A, 3B) resembles that of a single-pole high pass filter, since it exhibits a single pole and a 6 dB/octave slope at frequencies less than its natural frequency ($f_n$). The amplifier 200 may comprise an operational amplifier. The hydrophone may be modeled as a voltage source 202a and a capacitor 202b and resistor 202c in series; the capacitor 202b and the resistors 202c and 204 provide the single pole, and hence the 6 dB/octave slope. The natural frequency of the hydrophone 202 depends upon the value of the internal resistance 204 ($R_i$) of the amplifier 200, the resistance ($R_H$) of the resistor 202c, and the capacitance ($C_H$) of the capacitor 202b; this relationship is shown in Eqn. 1, below:

$$f_n = \frac{1}{2\pi(R_H + R_i)C}(Hz) \qquad\qquad (1)$$

For typical hydrophones, the natural frequency ranges from about 2 to 3 Hz.

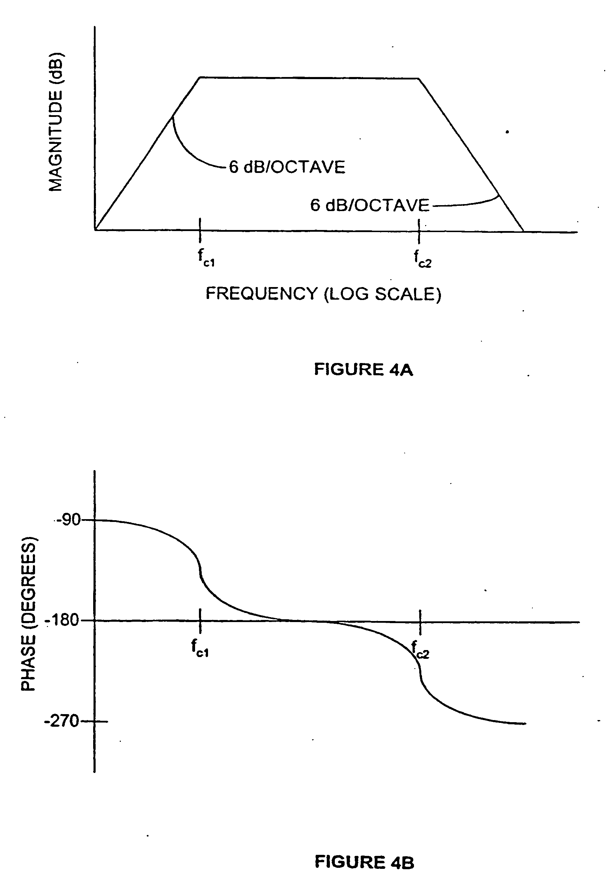

In contrast to the hydrophone 202, as illustrated in FIGS. 4A and 4B, the frequency response of a typical force-balance accelerometer, such as that disclosed in US-5852242, resembles an electrical circuit having a differentiating element in combination with a pair of simple lag elements. The resulting frequency response exhibits a 6 dB/octave slope at frequencies less than a first cut-off frequency ($F_{c1}$), a substantially flat response between the first cut-off frequency ($F_{c1}$) and a second cut-off frequency ($F_{c2}$), and a -6 dB/octave slope at frequencies greater than the second cut-off frequency ($F_{c2}$). For typical force-balance accelerometers, the first cut-off frequency ($F_{c1}$) ranges from about 1 to 10 Hz, and the second cut-off frequency ($F_{c2}$) ranges from about 1K to 100K Hz.

For the reasons explained above, hydrophones and accelerometers have different frequency response characteristics. Accordingly, hydrophones and accelerometers are not naturally suited to eliminate ghost signals 166 across the whole spectrum of desired frequency. To use a hydrophone with an accelerometer advantageously, the frequency response of the hydrophone must match the frequency response of the accelerometer.

The present invention is directed to overcoming one or more of the limitations of conventional hydrophones.

According to the present invention there is provided an apparatus as claimed in claim 1 and a method as claimed in claim 9.

A hydrophone assembly is provided that includes a hydrophone and a hydrophone filter coupled to the hydrophone. The frequency response of the hydrophone assembly matches the frequency response of an accelerometer.

An apparatus for measuring seismic waves is provided that includes an accelerometer and a hydrophone assembly. The hydrophone assembly includes a hydrophone and a hydrophone filter coupled to the hydrophone. The frequency response of the hydrophone assembly matches the frequency response of an accelerometer.

A marine seismic acquisition system is provided that includes a seismic source for generating seismic energy, a hydrophone for detecting seismic energy, a hydrophone filter coupled to the hydrophone, an accelerometer for detecting seismic energy, a seismic recorder coupled to the accelerometer and the hydrophone filter, and a controller coupled to the seismic source and seismic recorder for controlling and monitoring the operation of the seismic source and seismic recorder. The frequency response of the combination of the hydrophone and hydrophone filter matches the frequency response of the accelerometer.

A method of providing a hydrophone assembly having a frequency response that matches that of an accelerometer is provided that includes filtering the output of the hydrophone with a circuit that provides a differentiator and a pair of simple lags.

A method of measuring seismic energy using a hydrophone assembly and an accelerometer is provided that includes placing the hydrophone assembly and accelerometer in a body of water, generating seismic energy in the body of water, measuring the seismic energy using the hydrophone assembly and the accelerometer, scaling the output of either the accelerometer or hydrophone assembly, and generating an output signal substantially free from surface ghost signals by summing scaled output with the non-scaled output. The frequency response of the hydrophone assembly matches the frequency response of the accelerometer.

Various embodiments of the present invention will now be described, by way of example only, and with reference to the accompanying drawings in which:

FIG. 1A is a cross-sectional side view of a typical hydrophone.

FIG. 1B is an illustration of the use of a ocean bottom cable in conjunction with seismic equipment for petroleum exploration.

FIG. 1C is a graphical illustration of the use of the output of a hydrophone and an accelerometer to negate the influence of surface ghost signals.

FIG. 2 is an electrical schematic model of a hydrophone-amplifier.

FIG. 3A is a graphical illustration of the frequency response (magnitude) of a hydrophone coupled to an amplifier.

FIG. 3B is a graphical illustration of the frequency response (phase) of a hydrophone coupled to an amplifier.

FIG. 4A is a graphical illustration of the frequency response (magnitude) of a typical force-balance accelerometer.

FIG. 4B is a graphical illustration of the frequency response (phase) of a typical force-balance accelerometer.

FIG. 5 is a schematic illustration of an embodiment of a hydrophone including a filter.

FIG. 6A is a graphical illustration of the frequency response (magnitude) of the hydrophone and filter of FIG. 5.

FIG. 6B is a graphical illustration of the frequency response (phase) of a hydrophone and filter of FIG. 5.

FIG. 7 is a schematic illustration of a marine seismic acquisition system.

FIG. 8 is an illustration of the frequency response of an exemplary embodiment of a geophone to particle motion.

FIG. 9 is an illustration of the frequency response of an exemplary embodiment of a force-balance accelerometer to particle motion.

FIG. 10 is an illustration of the frequency response of an exemplary embodiment of a hydrophone with a filter to particle motion.

A hydrophone and filter assembly for use in a marine seismic acquisition system is provided. The hydrophone and filter assembly have a frequency response that closely resembles that of an accelerometer.

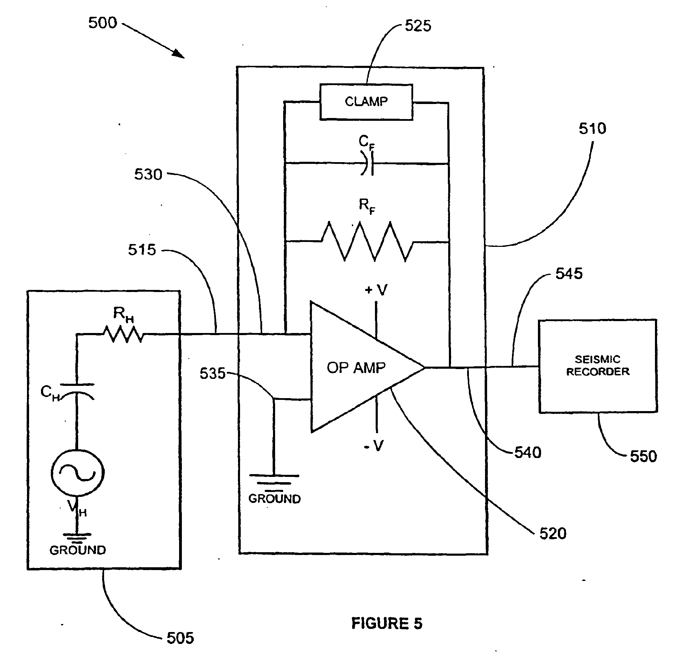

Referring to FIG. 5, a hydrophone and filter assembly 500 includes a conventional hydrophone 505 and a hydrophone filter 510. As described below, the hydrophone and filter assembly 500 preferably have a frequency response that closely matches the frequency response of a force-balance accelerometer.

The hydrophone 505 includes a voltage source $V_H$, a capacitor $C_H$, and a resistor $R_H$. The hydrophone 505 may comprise any number of conventional commercially available hydrophones such as, for example, Benthos AQ5. In a preferred embodiment, the hydrophone 505 comprises a model Preseis 2524 available from Input/Output in Stafford, TX in order to optimally provide operation to increased depths.

The hydrophone filter 510 is coupled to the output 515 of the hydrophone 505. The hydrophone filter 510 preferably includes an op amp 520, a resistor $R_F$, a capacitor $C_F$, and a clamp 525. The op amp 520 includes a pair of inputs, 530 and 535, and an output 540. The first input 530 of the op amp 520 is coupled to the output 515 of the hydrophone 505, the resistor $R_F$, the capacitor $C_F$, and the clamp 525. The second input of the op amp 520 is coupled to ground. The output 540 of the op amp 520 is coupled to the resistor $R_F$, the capacitor $C_F$, and the clamp 525. In a preferred embodiment, the output 540 of the op amp 520 is further coupled to the input 545 of a conventional seismic recorder 550.

The op amp 520 may comprise any number of conventional commercially available op amps such as, for example, Analog Devices AD 824. In a preferred embodiment, the op amp 520 comprises an OP 134 available from Burr-Brown in order to optimally provide high gain over a wide bandwidth.

The resistor $R_F$ may comprise any number of conventional commercially available resistors such as, for example, KOA, IRC or DALE. In a preferred embodiment, the resistor $R_F$ comprises a model RK73H2A available from KOA having a resistance ranging from about 1050 to 1070 ohms in order to optimally provide a high frequency pole.

The capacitor $C_F$ may comprise any number of conventional commercially available capacitors. In an exemplary embodiment, the capacitor $C_F$ is integral to the hydrophone 505.

In a particularly preferred embodiment, the product of the resistance and capacitance of the resistor $R_F$ and the capacitor $C_F$ provide a high-frequency cutoff of around 20 KHz.

The clamp 525 functions to limit the excursion of the electrical signals by clipping them off at predetermined levels. In a preferred embodiment, the clamp 525 is selected to clip the electrical signals when their excursion exceeds about 4.0 to 4.5 volts. The clamp 525 may comprise any number of conventional commercially available camping circuits. In an alternative preferred embodiment, the clamp 525 is omitted for circumstances in which excessive signal excursion is not present, or does not present a hazard to the operation of the system.

The laplace transfer of the transfer function of the hydrophone and filter assembly 500 may be expressed as follows.

$$\frac{-R_F C_H s}{(1+R_F C_F s)(1+R_H C_H s)} \tag{2}$$

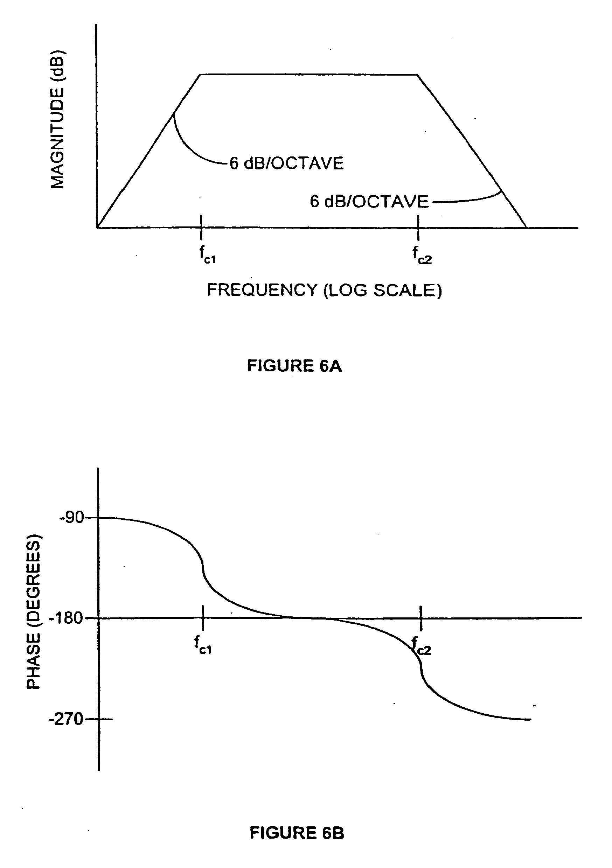

Thus, the hydrophone and filter assembly 500 provides a circuit including a differentiator and a pair of simple lags. The corresponding frequency response for the hydrophone and filter assembly 500 is illustrated in FIGS. 6A and 6B. The resulting frequency response exhibits a 6 dB/octave slope at frequencies less than a first cut-off frequency ($F_{c1}$), a substantially flat response between the first cut-off frequency ($F_{c1}$) and a second cut-off frequency ($F_{c2}$), and a -6 dB/octave slope at frequencies greater than the second cut-off frequency ($F_{c2}$). In a preferred embodiment, the first cut-off frequency ($F_{c1}$) ranges from about 1K to 1.1K Hz, and the second cut-off frequency ($F_{c2}$) ranges from about 20K to 20.2K Hz in order to optimally detect the acoustic signals generated using typical seismic acquisition systems.

In an exemplary embodiment, the hydrophone 505 has a natural frequency of about 2.5 Hz, the resistor $R_H$ has a resistance of about 2.133 M$\Omega$, and the capacitor $C_H$ has a capacitance of about 75 pF. These operating parameters provided a first cut-off frequency ($F_{c1}$) of about 15.69 Hz and a second cut-off frequency ($F_{c2}$) of about 6289 Hz.

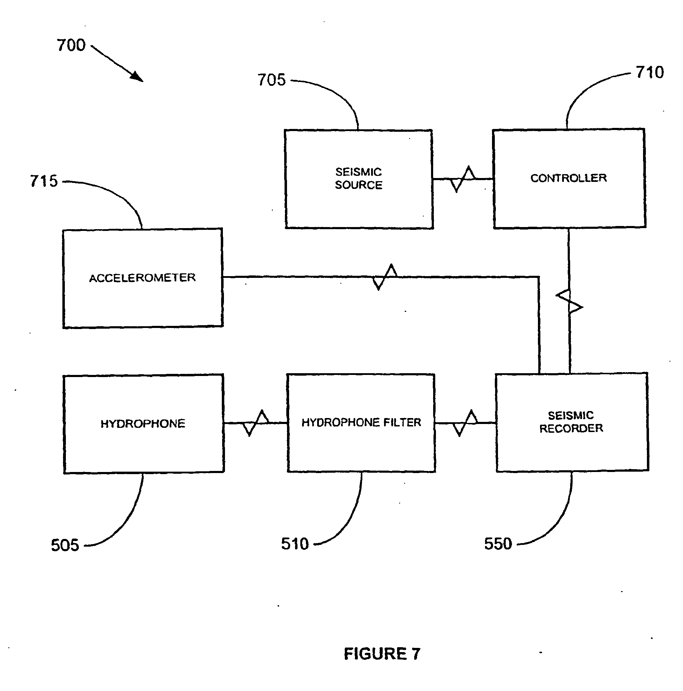

Referring now to FIG. 7, in a preferred embodiment, the hydrophone 505, hydrophone filter 510, and the seismic recorder 550 are used in a marine seismic acquisition system 700 that further includes a seismic source 705, a controller 710, and an accelerometer 715.

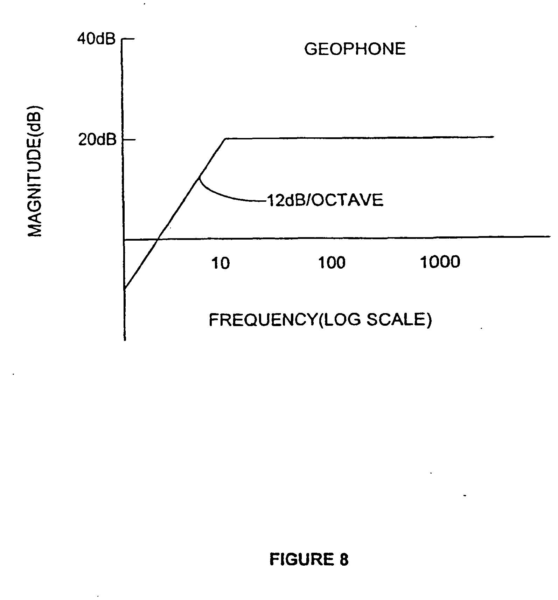

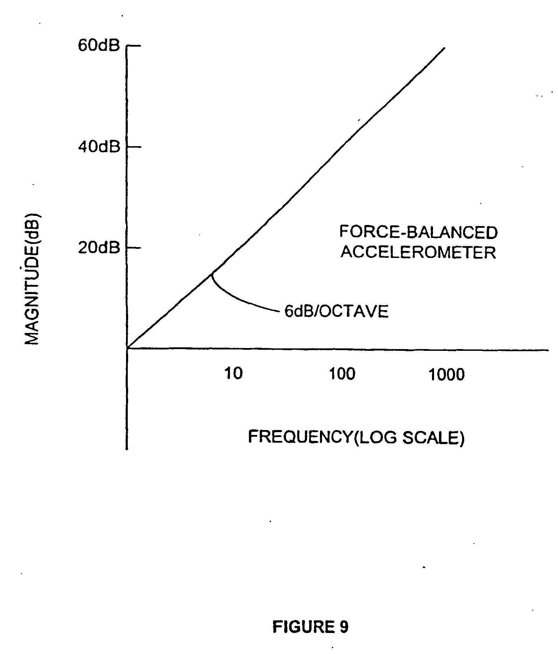

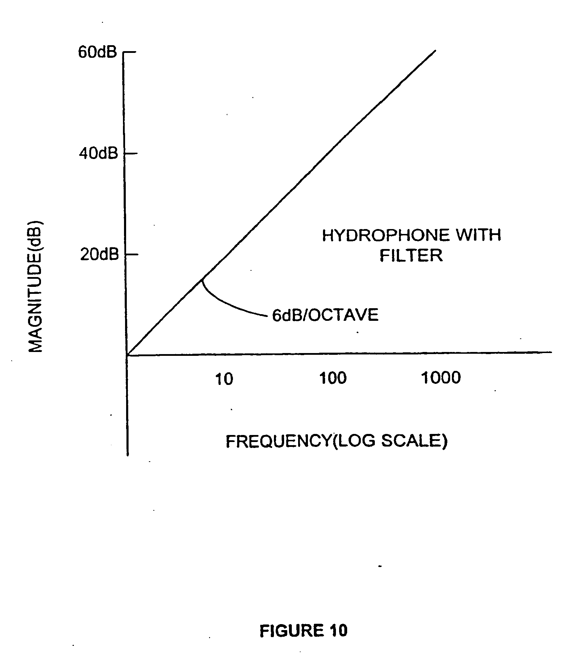

Referring now to FIGS. 8, 9 and 10, the frequency response of a geophone, a force-balance accelerometer 715 and a hydrophone 505 including a filter 510 in response to particle motion are illustrated. As shown in FIGS. 9 and 10, the accelerometer 715 and the hydrophone 505 and filter 510 exhibit the same frequency response to particle motion.

A hydrophone assembly has been described that includes a hydrophone and a hydrophone filter coupled to the hydrophone. The frequency response of the hydrophone assembly matches the frequency response of an accelerometer. In a preferred embodiment, the hydrophone includes a resistor and a capacitor. In a preferred embodiment, the hydrophone filter includes an operational amplifier, a resistor, and a capacitor. In a preferred embodiment, the frequency response of the hydrophone assembly matches that of a differentiator in combination with a pair of simple lags. In a preferred embodiment, the frequency response of the hydrophone assembly exhibits a 6 dB/octave slope for frequencies less than a first cut-off frequency, exhibits a flat response for frequencies between the first cut-off frequency and a second cut-off frequency, and exhibits a -6 dB/octave slope for frequencies greater than the second cut-off frequency.

An apparatus for measuring seismic waves has also been described that includes an accelerometer and a hydrophone assembly. The hydrophone assembly includes a hydrophone and a hydrophone filter coupled to the hydrophone. The frequency response of the hydrophone assembly matches the frequency response of an accelerometer. In a preferred embodiment, the hydrophone includes a resistor and a capacitor. In a preferred embodiment, the hydrophone filter includes an operational amplifier, a resistor, and a capacitor.

In a preferred embodiment, the frequency response of the hydrophone assembly matches that of a differentiator in combination with a pair of simple lags. In a preferred embodiment, the frequency response of the hydrophone assembly exhibits a 6 dB/octave slope for frequencies less than a first cut-off frequency, exhibits a flat response for frequencies between the first cut-off frequency and a second cut-off frequency, and exhibits a -6 dB/octave slope for frequencies greater than the second cut-off frequency.

A marine seismic acquisition system has been described that includes a seismic source for generating seismic energy, a hydrophone for detecting seismic energy, a hydrophone filter coupled to the hydrophone, an accelerometer for detecting seismic energy, a seismic recorder coupled to the accelerometer and the hydrophone filter, and a controller coupled to the seismic source and seismic recorder for controlling and monitoring the operation of the seismic source and seismic recorder. The frequency response of the combination of the hydrophone and hydrophone filter matches the frequency response of the accelerometer. In a preferred embodiment, the hydrophone includes a resistor and a capacitor. In a preferred embodiment, the hydrophone filter includes an operational amplifier, a resistor, and a capacitor. In a preferred embodiment, the frequency response of the hydrophone assembly matches that of a differentiator in combination with a pair of simple lags. In a preferred embodiment, the frequency response of the hydrophone assembly exhibits a 6 dB/octave slope for frequencies less than a first cut-off frequency, exhibits a flat response for frequencies between the first cut-off frequency and a second cut-off frequency, and exhibits a -6 dB/octave slope for frequencies greater than the second cut-off frequency.

A method of providing a hydrophone assembly having a frequency response that matches that of an accelerometer has been described that includes filtering the output of the hydrophone with a circuit that provides a differentiator and a pair of simple lags. In a preferred embodiment, the frequency response of the hydrophone assembly exhibits a slope of 6dB/octave for frequencies less than a first cut-off frequency, exhibits a flat response for frequencies between the first cut-off frequency and a second cut-off frequency, and exhibits a -6 dB/octave slope for frequencies greater than the second cut-off frequency.

A method of measuring seismic energy using a hydrophone assembly and an accelerometer has been described that includes placing the hydrophone assembly and accelerometer in a body of water, generating seismic energy in the body of water, measuring the seismic energy using the hydrophone assembly and the accelerometer, scaling the output of either the accelerometer or hydrophone assembly, and generating an output signal substantially free from surface ghost signals by summing scaled output with the non-scaled output. The frequency response of the hydrophone assembly matches the frequency response of the accelerometer. In a preferred embodiment, the frequency response of the hydrophone assembly exhibits a slope of 6dB/octave for frequencies less than a first cut-off frequency, exhibits a flat response for frequencies between the first cut-off frequency and a second cut-off frequency, and exhibits a -6 dB/octave slope for frequencies greater than the second cut-off frequency.

**Claims**

1. An apparatus for detecting seismic energy comprising:

    an accelerometer;
    a hydrophone assembly comprising a hydrophone (505) and a hydrophone filter (510) coupled to said hydrophone (505) to match a frequency response of said hydrophone assembly to a frequency response of said accelerometer, said hydrophone filter (510) comprising an operational amplifier (520), a resistor ($R_F$) and a capacitor ($C_F$);
    wherein said first input (530) of said operational amplifier (520) is coupled to said resistor ($R_F$);

    **characterised in that**:

    said first input (530) of said operational amplifier (520) is coupled to an output (515) of said hydrophone (505) and said capacitor ($C_F$) and an output (540) of said operational amplifier (520) is coupled to said resistor ($R_F$) and said capacitor ($C_F$); and
    wherein the frequency response of said hydrophone assembly matches that of a differentiator in combination with a pair of simple lag elements.

2. An apparatus as claimed in claim 1, wherein a second input (535) of said operational amplifier (520) is coupled to ground.

3. An apparatus as claimed in claim 1 or 2, wherein said resistor ($R_F$) and said capacitor ($C_F$) are coupled in parallel between said first input (530) of said operational amplifier (520) and said output (540) of said operational amplifier (520).

4. An apparatus as claimed in claim 1, 2 or 3, wherein said accelerometer comprises a force balance accelerometer.

5. An apparatus as claimed in any preceding claim, wherein a Laplace transfer of a transfer function of said hydrophone (505) and said hydrophone filter (510) is expressed as:

$$\frac{-R_F C_H s}{(1 + R_F C_F s)(1 + R_H C_H s)}$$

    wherein $R_F$ is a resistance of said resistor in said hydrophone filter (510), $C_F$ is a capacitance of said capacitor in said hydrophone filter (510), $R_H$ is a resistance of a resistor in said hydrophone (505) and $C_H$ is a capacitance of a capacitor in said hydrophone (505).

6. An apparatus as claimed in any preceding claim, wherein a product of a resistance of said resistor ($R_F$) coupled to said operational amplifier (520) and a capacitance of said capacitor ($C_F$) coupled to said operational amplifier (520) provide a high frequency cut-off.

7. An apparatus as claimed in any preceding claim, further comprising a clamp (525) coupled to said first input (530) of said operational amplifier (520) and said output (540) of said operational amplifier (520).

8. An apparatus as claimed in any preceding claim, further comprising a seismic recorder (550) coupled to said output (540) of said operational amplifier (520).

9. A method of detecting seismic energy, comprising:

    providing an accelerometer;
    providing a hydrophone assembly comprising a hydrophone (505) and a hydrophone filter (510) coupled to said hydrophone (505) to match a frequency response of said hydrophone assembly to a frequency response of said accelerometer, said hydrophone filter (510) comprising an operational amplifier (520), a resistor ($R_F$) and a capacitor ($C_F$);

coupling said first input (530) of said operational amplifier (520) to said resistor ($R_F$);

**characterised in that** said method further comprises:

coupling said first input (530) of said operational amplifier (520) to an output (515) of said hydrophone (505) and said capacitor ($C_F$) and coupling an output (540) of said operational amplifier (520) to said resistor ($R_F$) and said capacitor ($C_F$); and
wherein the frequency response of said hydrophone assembly matches that of a differentiator in combination with a pair of simple lag elements.

10. A method as claimed in claim 9, further comprising coupling a second input (535) of said operational amplifier (520) to ground.

11. A method as claimed in claim 9 or 10, further comprising coupling said resistor ($R_F$) and said capacitor ($C_F$) in parallel between said first input (530) of said operational amplifier (520) and said output (540) of said operational amplifier (520).

12. A method as claimed in claim9, 10 or 11, wherein said accelerometer comprises a force balance accelerometer.

13. A method as claimed in any of claims 9-12, wherein a Laplace transfer of a transfer function of said hydrophone (505) and said hydrophone filter (510) is expressed as:

$$\frac{-R_F C_H s}{(1 + R_F C_F s)(1 + R_H C_H s)}.$$

wherein $R_F$ is a resistance of said resistor in said hydrophone filter (510), $C_F$ is a capacitance of said capacitor in said hydrophone filter (510), $R_H$ is a resistance of a resistor in said hydrophone (505) and $C_H$ is a capacitance of a capacitor in said hydrophone (505).

14. A method as claimed in any of claims 9-13, wherein a product of a resistance of said resistor ($R_F$) coupled to said operational amplifier (520) and a capacitance of said capacitor ($C_F$) coupled to said operational amplifier (520) provide a high frequency cut-off.

15. A method as claimed in any of claims 9-14, further comprising coupling a clamp (525) to said first input (530) of said operational amplifier (520) and said output (540) of said operational amplifier (520).

16. A method as claimed in any of claims 9-15, further comprising coupling a seismic recorder (550) to said output (540) of said operational amplifier (520).

**Patentansprüche**

1. Vorrichtung zum Ermitteln von seismischer Energie, umfassend:

einen Beschleunigungsaufnehmer;
eine Hydrofoneinheit, die ein Hydrofon (505) und ein Hydrofonfilter (510) umfasst, welches mit dem Hydrofon (505) zum Anpassen eines Frequenzgangs der Hydrofoneinheit an einen Frequenzgang des Beschleunigungsaufnehmers verbunden ist, wobei das Hydrofonfilter (510) einen Operationsverstärker (520), einen Widerstand ($R_F$) und einen Kondensator ($C_F$) umfasst;
wobei der erste Eingang (530) des Operationsverstärkers (520) mit dem Widerstand ($R_F$) verbunden ist;

**dadurch gekennzeichnet, dass**
der erste Eingang (530) des Operationsverstärkers (520) mit einem Ausgang (515) des Hydrofons (505) und des Kondensators ($C_F$) verbunden ist und ein Ausgang (540) des Operationsverstärkers (520) mit dem Widerstand ($R_F$) und dem Kondensator ($C_F$) verbunden ist; und

wobei der Frequenzgang der Hydrofoneinheit zu dem eines Differentiators in Kombination mit einem Paar von einfachen Verzögerungselementen passt.

2. Vorrichtung nach Anspruch 1, wobei ein zweiter Eingang (535) des Operationsverstärkers (520) mit Erde verbunden ist.

3. Vorrichtung nach Anspruch 1 oder 2, wobei der Widerstand ($R_F$) und der Kondensator ($C_F$) parallel zwischen dem ersten Eingang (530) des Operationsverstärkers (520) und dem Ausgang (540) des Operationsverstärkers (520) angeschlossen sind.

4. Vorrichtung nach Anspruch 1, 2 oder 3, wobei der Beschleunigungsaufnehmer einen kraftkompensierenden Beschleunigungsaufnehmer umfasst.

5. Vorrichtung nach einem der vorherigen Ansprüche, wobei eine Laplace-Transformation einer Übertragungsfunktion des Hydrofons (505) und des Hydrofonfilters (510) folgendemaßen ausgedrückt wird:

$$\frac{-R_F C_H s}{(1+R_F C_F s)(1+R_H C_H s)}$$

wobei $R_F$ ein Widerstandswert des Widerstandes im Hydrofonfilter (510) ist, $C_F$ eine Kapazität des Kondensators im Hydrofonfilter (510) ist, $R_H$ ein Widerstandswert eines Widerstandes im Hydrofon (505) und $C_H$ eine Kapazität eines Kondensators im Hydrofon (505) ist.

6. Vorrichtung nach einem der vorherigen Ansprüche, wobei ein Produkt aus einem Widerstandswert eines Widerstandes ($R_F$), der mit dem Operationsverstärker (520) verbunden ist, und einer Kapazität des Kondensators ($C_F$), der mit dem Operationsverstärker (520) verbunden ist, für einen Abschneidewert hoher Frequenz sorgt.

7. Vorrichtung nach einem der vorherigen Ansprüche, die ferner eine Klemmvorrichtung (525) umfasst, welche mit dem ersten Eingang (530) des Operationsverstärkers (520) und dem Ausgang (540) des Operationsverstärkers (520) verbunden ist.

8. Vorrichtung nach einem der vorherigen Ansprüche, die ferner einen Seismikrekorder (550) umfasst, welcher mit dem Ausgang (540) des Operationsverstärkers (520) verbunden ist.

9. Verfahren zum Ermitteln von seismischer Energie, umfassend:

Bereitstellen eines Beschleunigungsaufnehmers;
Bereitstellen einer Hydrofoneinheit, die ein Hydrofon (505) und ein Hydrofonfilter (510) umfasst, welches mit dem Hydrofon (505) zum Anpassen eines Frequenzgangs der Hydrofoneinheit an einen Frequenzgang des Beschleunigungsaufnehmers verbunden ist, wobei das Hydrofonfilter (510) einen Operationsverstärker (520), einen Widerstand ($R_F$) und einen Kondensator ($C_F$) umfasst;
Verbinden des ersten Eingangs (530) des Operationsverstärkers (520) mit dem Widerstand ($R_F$);

**dadurch gekennzeichnet, dass** das Verfahren ferner Folgendes umfasst:

Verbinden des ersten Eingangs (530) des Operationsverstärkers (520) mit einem Ausgang (515) des Hydrofons (505) und dem Kondensator ($C_F$) und Verbinden eines Ausgangs (540) des Operationsverstärkers (520) mit dem Widerstand ($R_F$) und dem Kondensator ($C_F$); und
wobei der Frequenzgang der Hydrofoneinheit zu dem eines Differentiators in Kombination mit einem Paar von einfachen verzögerungselementen passt.

10. Verfahren nach Anspruch 9, das ferner das Verbinden eines zweiten Eingangs (535) des Operationsverstärkers (520) mit Erde umfasst.

11. Verfahren nach Anspruch 9 oder 10, das ferner das Verbinden des Widerstandes ($R_F$) und des Kondensators ($C_F$) parallel zwischen dem ersten Eingang (530) des Operationsverstärkers (520) und dem Ausgang (540) des Operationsverstärkers (520) umfasst.

**12.** Verfahren nach Anspruch 9, 10 oder 11, wobei der Beschleunigungsaufnehmer einen kraftkompensierenden Beschleunigungsaufnehmer umfasst.

**13.** Verfahren nach einem der Ansprüche 9-12, wobei eine Laplace-Transformation einer Übertragungsfunktion des Hydrofons (505) und des Hydrofonfilters (510) folgendermaßen ausgedrückt wird:

$$\frac{-R_F C_H s}{(1+R_F C_F s)(1+R_H C_H s)}$$

wobei $R_F$ ein Widerstandswert des Widerstandes im Hydrofonfilter (510) ist, $C_F$ eine Kapazität des Kondensators im Hydrofonfilter (510) ist, $R_H$ ein Widerstandswert eines Widerstandes im Hydrofon (505) und $C_H$ eine Kapazität eines Kondensators im Hydrofon (505) ist.

**14.** Verfahren nach einem der Ansprüche 9-13, wobei ein Produkt aus einem Widerstandswert eines Widerstandes ($R_F$), der mit dem Operationsverstärker (520) verbunden ist, und einer Kapazität des Kondensators ($C_F$), der mit dem Operationsverstärker (520) verbunden ist, für einen Abschneidewert hoher Frequenz sorgt.

**15.** Verfahren nach einem der Ansprüche 9-14, das ferner das Verbinden einer Klemmvorrichtung (525) mit dem ersten Eingang (530) des Operationsverstärkers (520) und dem Ausgang (540) des Operationsverstärkers (520) umfasst.

**16.** Verfahren nach einem der Ansprüche 9-15, das ferner das Verbinden eines Seismikrekorders (550) mit dem Ausgang (540) des Operationsverstärkers (520) umfasst.

## Revendications

**1.** Appareil pour détecter une énergie sismique, comprenant ;

- un accéléromètre ;
- un système d'hydrophone comprenant un hydrophone (505) et un filtre d'hydrophone (510) couplé audit hydrophone (505) afin de faire correspondre une réponse en fréquence dudit système d'hydrophone à une réponse en fréquence dudit accéléromètre, lequel filtre d'hydrophone (510) comprend un amplificateur fonctionnel (520), une résistance ($R_F$) et un condensateur ($C_F$) ;

dans lequel ladite première entrée (530) dudit amplificateur fonctionnel (520) est couplée à ladite résistance ($R_F$) ; **caractérisé en ce que** :

- ladite première entrée (530) dudit amplificateur fonctionnel (520) est couplée à une sortie (515) dudit hydrophone (505) et dudit condensateur ($C_F$), et une sortie (540) dudit amplificateur fonctionnel (520) est couplée à ladite résistance ($R_F$) et audit condensateur ($C_F$) ; et

dans lequel la réponse en fréquence dudit système d'hydrophone correspond à celle d'un différentiateur en combinaison avec une paire d'éléments de retard simples.

**2.** Appareil selon la revendication 1, dans lequel une seconde entrée (535) dudit amplificateur fonctionnel (520) est couplée à la terre.

**3.** Appareil selon les revendications 1 ou 2, dans lequel ladite résistance ($R_F$) et ledit condensateur ($C_F$) sont couplés en parallèle entre ladite première entrée (530) dudit amplificateur fonctionnel (520) et ladite sortie (540) dudit amplificateur fonctionnel (520).

**4.** Appareil selon les revendications 1, 2 ou 3, dans lequel ledit accéléromètre comprend un accéléromètre à équilibre de forces.

**5.** Appareil selon l'une quelconque des revendications précédentes, dans lequel un transfert de Laplace d'une fonction de transfert dudit hydrophone (505) et dudit filtre d'hydrophone (510) est exprimé sous la forme suivante :

$$\frac{-R_F C_H s}{(1 + R_F C_F s)(1 + R_H C_H s)}$$

dans laquelle $R_F$ est une résistance de ladite résistance dans ledit filtre d'hydrophone (510), $C_F$ est une capacité du condensateur dans ledit filtre d'hydrophone (510), $R_H$ est une résistance de la résistance dans ledit hydrophone (505), et $C_H$ est une capacité du condensateur dans ledit hydrophone (505).

**6.** Appareil selon l'une quelconque des revendications précédentes, dans lequel le produit de la résistance de ladite résistance ($R_F$) couplée audit amplificateur fonctionnel (520) et de la capacité dudit condensateur ($C_F$) couplé audit amplificateur fonctionnel (520) donne une coupure haute fréquence.

**7.** Appareil selon l'une quelconque des revendications précédentes, comprenant en outre une pince (525) couplée à ladite première entrée (530) dudit amplificateur fonctionnel (520) et à ladite sortie (540) dudit amplificateur fonctionnel (520).

**8.** Appareil selon l'une quelconque des revendications précédentes, comprenant en outre un enregistreur sismique (550) couplé à ladite sortie (540) dudit amplificateur fonctionnel (520).

**9.** Procédé de détection d'énergie sismique, consistant à :

- utiliser un accéléromètre ;
- utiliser un système d'hydrophone comprenant un hydrophone (505) et un filtre d'hydrophone (510) couplé audit hydrophone (505) afin de faire correspondre une réponse en fréquence dudit système d'hydrophone à une réponse en fréquence dudit accéléromètre, lequel filtre d'hydrophone (510) comprend un amplificateur fonctionnel (520), une résistance ($R_F$) et un condensateur ($C_F$) ;
- coupler ladite première entrée (530) dudit amplificateur fonctionnel (520) à ladite résistance ($R_F$) ;

**caractérisé en ce que** ledit procédé consiste en outre à :

- coupler ladite première entrée (530) dudit amplificateur fonctionnel (520) à une sortie (515) dudit hydrophone (505) et dudit condensateur ($C_F$), et coupler une sortie (540) dudit amplificateur fonctionnel (520) à ladite résistance ($R_F$) et audit condensateur ($C_F$) ; et

dans lequel la réponse en fréquence dudit système d'hydrophone correspond à celle d'un différentiateur en combinaison avec une paire d'éléments de retard simples.

**10.** Procédé selon la revendication 9, consistant en outre à coupler une seconde entrée (535) dudit filtre fonctionnel (520) à la terre.

**11.** Procédé selon les revendications 9 ou 10, consistant en outre à coupler ladite résistance ($R_F$) et ledit condensateur ($C_F$) en parallèle entre ladite première entrée (530) dudit amplificateur fonctionnel (520) et ladite sortie (540) dudit amplificateur fonctionnel (520).

**12.** Procédé selon les revendications 9, 10 ou 11, dans lequel ledit accéléromètre comprend un accéléromètre à équilibre de forces.

**13.** Procédé selon l'une quelconque des revendications 9 à 12, dans lequel un transfert de Laplace d'une fonction de transfert dudit hydrophone (505) et dudit filtre d'hydrophone (510) est exprimé sous la forme suivante :

$$\frac{-R_F C_H s}{(1 + R_F C_F s)(1 + R_H C_H s)}$$

dans laquelle $R_F$ est une résistance de ladite résistance dans ledit filtre d'hydrophone (510), $C_F$ est une capacité du condensateur dans ledit filtre d'hydrophone (510), $R_H$ est une résistance de la résistance dans ledit hydrophone (505), et $C_H$ est une capacité du condensateur dans ledit hydrophone (505).

**14.** Procédé selon l'une quelconque des revendications 9 à 13, dans lequel le produit de la résistance de ladite résistance ($R_F$) couplée audit amplificateur fonctionnel (520) et de la capacité dudit condensateur ($C_F$) couplé audit amplificateur fonctionnel (520) donne une coupure haute fréquence.

**15.** Procédé selon l'une quelconque des revendications 9 à 14, consistant en outre à coupler une pince (525) à ladite première entrée (530) dudit amplificateur fonctionnel (520) et à ladite sortie (540) dudit amplificateur fonctionnel (520).

**16.** Procédé selon l'une quelconque des revendications 9 à 15, consistant en outre à coupler un enregistreur sismique (550) à ladite sortie (540) dudit amplificateur fonctionnel (520).

100

FLUID PRESSURE

FIGURE 1A

**FIGURE 1B**

FIGURE 1C

**FIGURE 2**

FIGURE 3A

FIGURE 3B

**FIGURE 4A**

**FIGURE 4B**

EP 1 847 850 B1

FIGURE 5

18

FIGURE 6A

FIGURE 6B

700

715

705

710

SEISMIC
SOURCE

CONTROLLER

ACCELEROMETER

HYDROPHONE

HYDROPHONE FILTER

SEISMIC
RECORDER

505

510

550

FIGURE 7

EP 1 847 850 B1

FIGURE 8

21

FIGURE 9

**FIGURE 10**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5852242 A